Europäisches Patentamt

European Patent Office

Office européen des brevets

(11) Numéro de publication: **0 241 066 B1**

(12) **FASCICULE DE BREVET EUROPEEN**

(45) Date de publication de fascicule du brevet:
06.03.91

(51) Int. Cl.⁵: **C30B 19/06**

(21) Numéro de dépôt: **87200440.3**

(22) Date de dépôt: **10.03.87**

(54) **Creuset pour épitaxie liquide multibains.**

(30) Priorité: **21.03.86 FR 8604080**

(43) Date de publication de la demande:
**14.10.87 Bulletin 87/42**

(45) Mention de la délivrance du brevet:
**06.03.91 Bulletin 91/10**

(84) Etats contractants désignés:
**DE FR GB IT**

(56) Documents cités:

**PATENT ABSTRACTS OF JAPAN, vol. 6, no. 32 (E-96)[910], 26 février 1982; & JP-A-56 152 233 (SANYO DENKI K.K.) 25-11-1981**

(73) Titulaire: **PHILIPS COMPOSANTS**
**117, quai du Président Roosevelt**
**F-92130 Issy les Moulineaux(FR)FR**

Titulaire: **N.V. Philips' Gloeilampenfabrieken**
**Groenewoudseweg 1**
**NL-5621 BA Eindhoven(NL)DE**

(72) Inventeur: **Fromage, Francis Société Civile S.P.I.D.**
**209, rue de l'Université**
**F-75007 Paris(FR)**
Inventeur: **Piche, Béatrice Société Civile S.P.I.D.**
**209, rue de l'Université**
**F-75007 Paris(FR)**
Inventeur: **Mahieu, Marc Société Civile S.P.I.D.**
**209, rue de l'Université**
**F-75007 Paris(FR)**

(74) Mandataire: **Jacquard, Philippe et al**
**Société Civile S.P.I.D. 156, Boulevard Haussmann**
**F-75008 Paris(FR)**

## Description

La présente invention a pour objet un creuset pour épitaxie liquide multi-bains dans lequel des substrats à épitaxier sont disposés dans une tirette porte-substrats dont le déplacement permet de mettre les substrats successivement en contact avec les différents bains d'épitaxie.

Des creusets multi-bains sont utilisés couramment dans l'industrie.Ceux-ci permettent soit de traiter un grand nombre de substrats mais le nombre de bains est limité à deux, soit de traiter nettement moins de substrats dans un nombre plus élevé de bains.

A la première catégorie appartient par exemple le creuset décrit dans le brevet français 1600341 déposé par la Demanderesse. Celui-ci permet d'épitaxier un nombre élevé de substrats disposés horizontalement. Par translation d'une tirette porte-substrats, on met ces derniers en contact avec l'un ou l'autre de deux bains d'épitaxie. On peut ainsi réaliser une épitaxie à deux couches, ou bien une épitaxie multi-couches ne présentant que deux types de couches alternées.

A la deuxième catégorie appartient le creuset décrit dans la demande de brevet japonais publiée sous le numéro 59-26997 (SUMITOMO). Le porte-substrats n'est pas une simple tirette mais comporte trois plateaux communicants et superposés contenant des substrats à épitaxier et mis en contact par translation, successivement avec les différents bains d'épitaxie disposés dans des compartiments éspacés longitudinalement. Le mouillage des substrats contenus dans les trois plateaux superposés nécessite l'application d'une pression. La mise en oeuvre d'un tel creuset est en outre délicate, car on doit éviter toute solidification de la solution dans les canaux qui font communiquer entre eux les plateaux superposés. Enfin, on ne peut traiter avec un tel creuset un nombre élevé de substrats. Augmenter la longueur des plateaux conduit en effet à un creuset de longeur inacceptable. Augmenter leur largeur, c'est s'exposer à des difficultés lors de la translation des plateaux. Or les creusets sont en graphite, donc coûteux et fragiles.

L'invention propose un creuset dont la conception est adaptée à la réalisation d'épitaxies multi-bains d'un nombre élevé de substrats, tout en restant d'une utilisation simple.

Le creuset selon l'invention comporte á cet effet un compartiment dans lequel sont empilés alternativement des tiroirs d'étanchéité et des tiroirs porte-solution, chacun de ces derniers présentant une cavité destinée à recevoir une dite solution et présentant une partie inférieure débouchant à la face inférieure dudit tiroir porte-solution et les tiroirs d'étanchéité étant tels qu'ils referment la partie inférieure desdites cavités et en ce que la tirette porte-substrats est translatable dans le même plan que le tiroir inférieur de l'empilement des tiroirs entre une position arrière où elle est dégagée de l'empilement et une position avant où, après avoir chassé le tiroir inférieur de l'empilement, elle se trouve en dessous de l'empilement.

Le déplacement de la tirette porte-substrats permet de mettre les substrats en contact avec chacun des différents bains d'épitaxie. En effet, après l'évacuation d'un tiroir-d'étanchéité par la tirette porte-substrats, un tiroir porte solution devient alors le tiroir inférieur de l'empilement des tiroirs, et la solution qu'il contient vient mouiller les substrats de la tirette porte-substrats qui se trouve sous l'empilement des tiroirs. Selon une variante, la cavité desdits tiroirs porte-solution comporte au moins un évidement destiné à recevoir une phase solide permettant de maintenir ladite solution en saturation d'au moins un constituant.

Selon un mode de réalisation préféré, le compartiment comporte un fond présentant une ouverture disposée à l'aplomb de l'empilement de manière à permettre lors du retour de la tirette porte-substrat à sa position arrière, l'évacuation des bains d'épitaxie utilisés.

Le tiroir d'étanchéité est avantageusement une plaque pleine de même contour extérieur qu'un tiroir porte-solution.

L'invention sera mieux comprise à la lecture de la description qui va suivre donnée à titre d'exemple non limitatif en liaison avec les dessins qui représentent :
- Les figures 1a à 1e, en coupe longitudinale, un creuset selon l'invention dans différentes étapes illustrant une épitaxie avec un bain d'épitaxie.
- Les figures 2a et 2b, respectivement en coupe longitudinale et en vue de dessus, un tiroir porte-substrats selon l'invention.
- Les figures 3a et 3b, respectivement en coupe longitudinale et en vue de dessus, un corps de creuset selon l'invention.
- Les figures 4 a et 4b, respectivement en coupe longitudinale et en vue de dessus, une tirette porte-solution selon l'invention.
- Les figures 5a et 5b, respectivement en coupe longitudinale et en vue de dessus, une tirette d'étanchéité selon l'invention.
- La figure 6, une vue en perspective d'une extrémité du corps du creuset avant montage d'un élément de fermeture représenté en perspective à la figure 7.

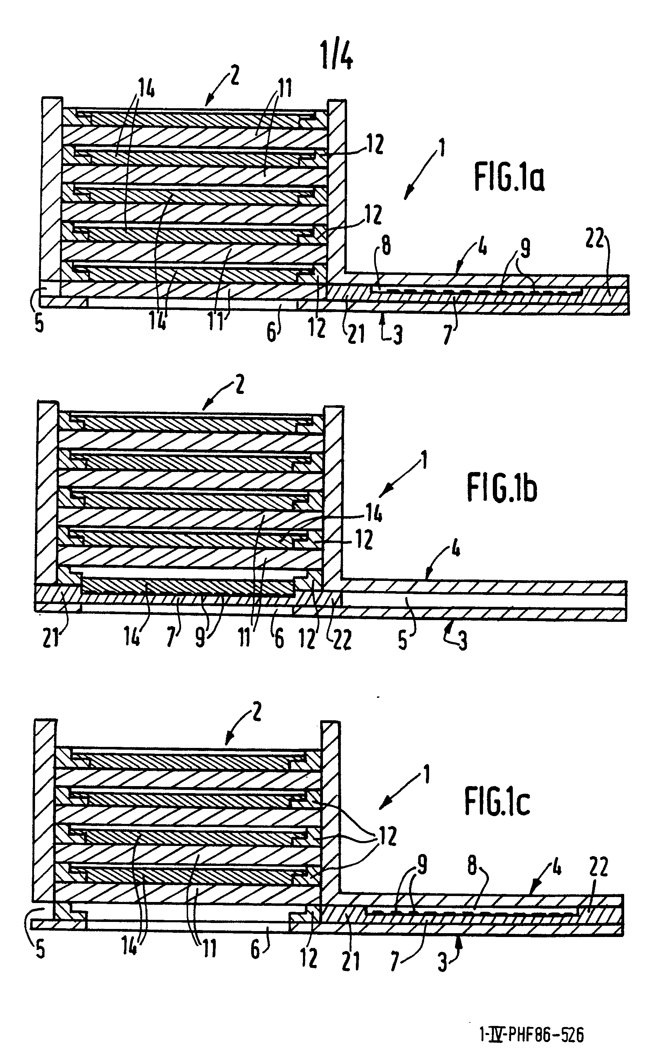

Selon la figure 1a, un creuset selon l'invention comporte un corps de creuset désigné par le repère général 1 et se composant d'un compartiment 2 et d'un plan de coulissement 3 recouvert en dehors du compartiment 2 par un bord supérieur 4, de manière à définir un canal de coulissement 5 de section rectangulaire.

Le compartiment 2 reçoit un empilement alterné de tiroirs d'étanchéïté 11 et de tiroirs porte-solution 12. Lorsque le creuset est mis en place dans une ampoule en quartz en vue de réaliser des opérations d'épitaxie, le tiroir inférieur de l'empilement 2 est un tiroir d'étanchéïté 11 qui se trouve à l'aplomb du canal 5.

Il y a autant de tiroirs porte-solution 12 remplis chacun d'une solution 14 que de couches à épitaxier. Les substrats 9 à épitaxier sont disposés dans un évidement 8 d'une tirette porte-substrat 7 qui se trouve en position arrière dans le canal 5 sous le bord supérieur 4.

On comprendra que la viscosité élevée des bains d'épitaxie permet d'obtenir une bonne étanchéité par le simple jeu de l'empilement des tiroirs. Les tiroirs porte-solution 2 ne sont pas fermés à leur partie inférieure, c'est-à-dire que les solutions 14 contenues dans ces tiroirs ne sont retenus que par la présence des tiroirs d'étanchéïté 11.

A la figure 1b, la tirette porte-substrats 7 à été translatée le long du plan de coulissement 3 de manière à venir en position avant en dessous de l'empilement des tiroirs, sa partie avant 21 ayant chassé le tiroir d'étanchéïté 11 qui se trouvait précédemment à l'aplomb du canal 5. Dans cette position, les substrats 9 sont mouillés par la solution 14 du tiroir porte-solution 12 qui se trouve être à la base de l'empilement des tiroirs 11 et 12.

A la figure 1c, après réalisation de l'opération d'épitaxie souhaitée, la tirette porte-substrats 7 a été ramenée dans sa position arrière ce qui a eu pour effet d'une part d'évacuer la solution 14 ayant servi à l'épitaxie à travers une ouverture 6 du plan de coulissement 3 vers un récipient non représenté, et d'autre part de faire tomber l'empilement d'un demi-pas, le tiroir porte-solution 12 vidé de sa solution étant maintenant à l'aplomb du canal 5.

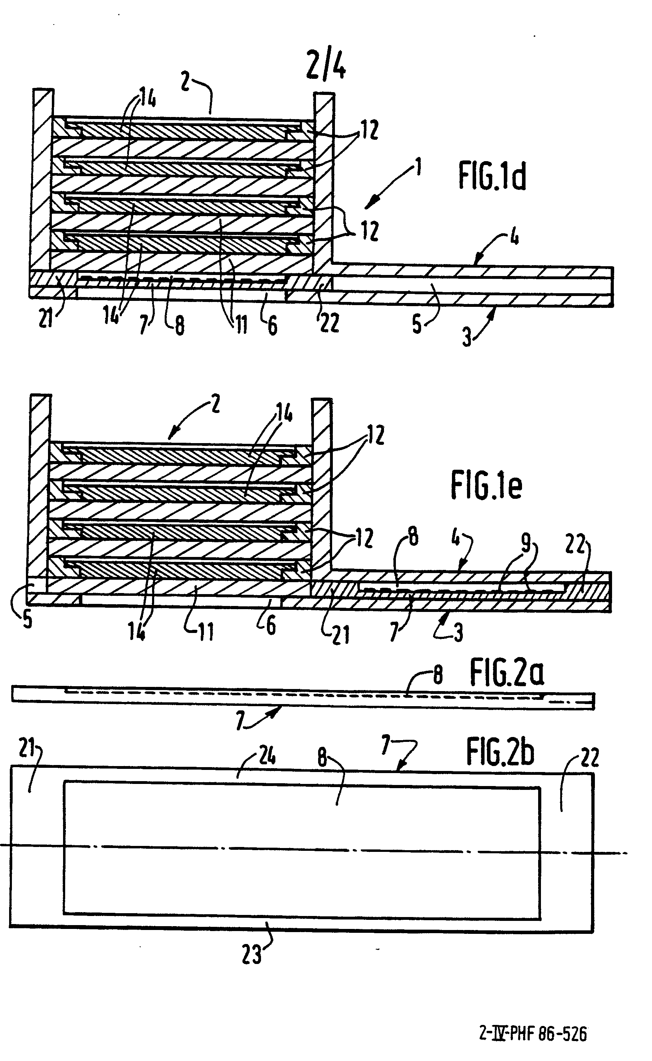

A la figure 1d, la tirette porte substrats 7 a été de nouveau amenée à sa position avant de manière à évacuer le tiroir porte-solution 12 précédemment utilisé.

A la figure 1e, la tirette porte-substrats 7 a été de nouveau amenée à sa position arrière. L'empilement tombe à nouveau d'un demi-pas, un tiroir d'étanchéïté 11 se trouvant à la partie inférieure de l'empilement et à l'aplomb du canal 5. On est alors dans une situation équivalente à celle de la figure 1a et les épitaxies successives vont pouvoir alors se poursuivre en actionnant de la manière décrite ci-dessus la tirette porte-substrats 7 entre sa position arrière et sa position avant.

Selon les figures 2a et 2b, la tirette porte-substrats 7 présente un évidement 8 dont la profondeur est égale à la hauteur des substrats 9 augmentée d'un faible jeu. Ceci a pour effet que, lors du retour de la tirette porte-substrats 7 à sa position arrière immédiatement après le dépôt d'une couche epitaxiale, comme entre les figures 1b et 1c, le bord inférieur du tiroir porte-solution 12 enlève la majeure partie de la solution. Ceci permet d'obtenir une bonne qualité de l'interface avec la couche épitaxiale suivante en raison du faible taux de mélange entre deux solutions 14 successives.

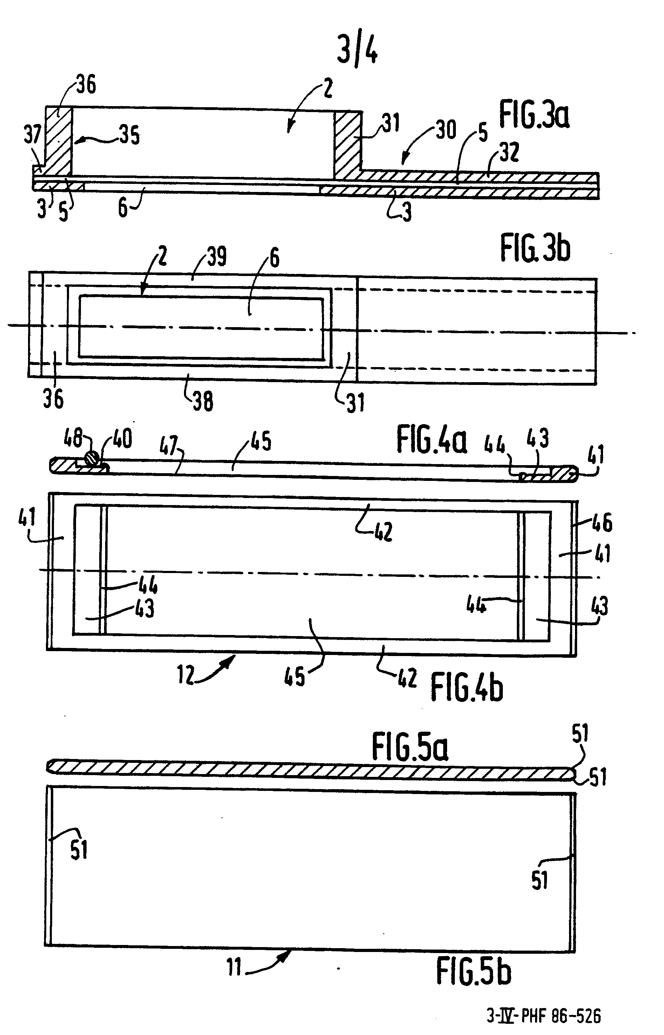

Selon les figures 3a et 3b, le corps du creuset comporte une plaque de base 3 dans laquelle est ménagée l'ouverture 6, et qui présente deux parois longitudinales 38 et 39 du compartiment 2. Deux éléments de fermeture 30 et 35 sont montés entre les extrémités des parois longitudinales 38 et 39 de manière à constituer les deux parois latérales 31 et 36 du compartiment 2, et à former grâce à des prolongements 32 et 37 les parties supérieures du canal 5 à chacune des deux parties de celui-ci.

Selon les figures 4a et 4b, un tiroir porte solution 12 présente en contour général rectangulaire de même section au jeu près que le compartiment 2. Il comporte deux parois longitudinales 42 et deux parois transversales 41.

Les parois transversales 41 se prolongent chacune en direction de l'intérieur du tiroir, par un prolongement 43 muni d'un rebord 44 de manière à définir un évidement 40 permettant de recevoir une phase solide 48 permettant de maintenir la solution 14 en saturation d'au moins un constituant. La solution 14 est contenue dans une cavité 45 bordée par les parois longitudinales 42 et le rebord 44 et dont la partie inférieure qui débouche à la face inférieure 47 du tiroir 12 est refermée par un tiroir d'étanchéïté 11 constitué d'une simple plaque rectangulaire pleine de mêmes dimensions que le tiroir 12. (fig. 5a et 5b).

On remarquera que le déplacement vertical des tiroirs 11 et 12 est facilité par la présence de chanfreins respectivement 51 et 46 sur leurs parois latérales.

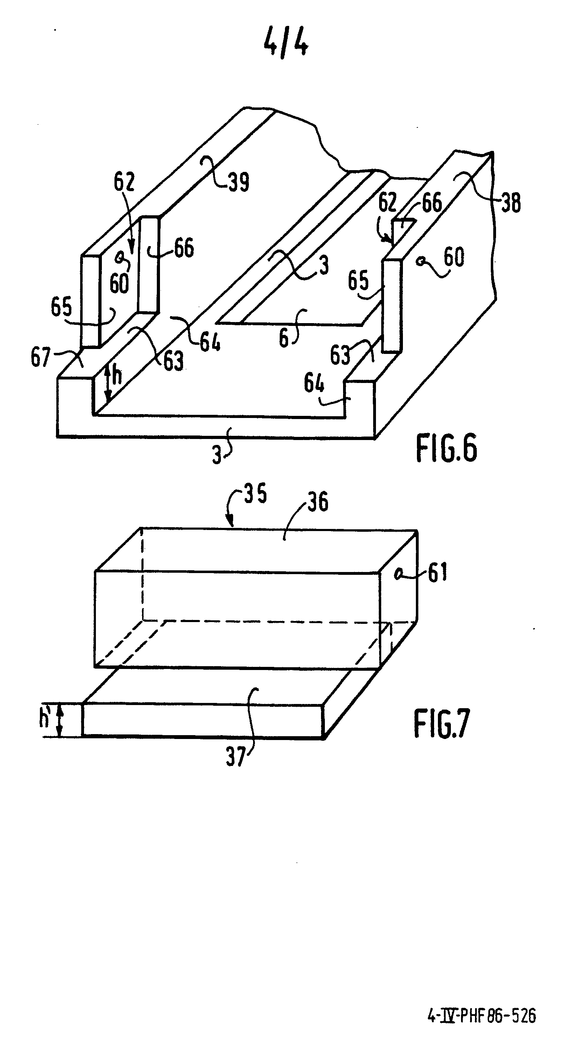

Les figures 6 et 7 illustrent le montage de l'élément de fermeture 35. Un montage similaire est utilisable pour l'élément 30 dont le prolongement 32 a une longueur plus importante car elle doit tenir compte de la longueur de la tirette porte-substrats 7.

L'élément de fermeture 35 comporte un bloc 36 constituant une paroi latérale du compartiment 2 et surmontant un prolongement 37 de plus faible largeur mais dépassant à une extrémité, de telle sorte que le canal 5 est recouvert par le prolongement 37 au delà de l'aplomb du bloc 36, de manière à recevoir l'extrémité avant 21 de la tirette porte substrat 7.

Les parois longitudinales 38 et 39 de la plaque de base 3 se terminent par une extrémité amincie 62 présentant un alésage 60 et délimité par une paroi verticale 66 formant butée pour le bloc 36 sur laquelle repose le bloc 36. La hauteur h' du prolongement 37 est inférieure à la hauteur h d'un rebord 64 dont la paroi longitudinale 63 et son prolongement 67 constituent la partie supérieure. La différence h - h' est égale à la hauteur du canal 5, c'est-à-dire aux jeux près à la hauteur commune des tiroirs 11 et 12 et de la tirette 7.

L'invention ne se limite pas aux modes de réalisation décrits et représentés. Il est ainsi possible de réaliser différemment l'évacuation de solutions 14 en ne munissant pas la plaque de base 3 de l'ouverture 6. Dans ce cas, les bains 14 sont évacués en même temps que les tiroirs porte-solution 12.

## Revendications

1. Creuset pour épitaxie liquide multi-bains dans lequel des substrats à épitaxier sont disposés dans une tirette porte-substrats dont le déplacement permet de mettre les substrats successivement en contact avec les différents bains d'épitaxie, ledit creuset comportant un compartiment (2) dans lequel sont empilés alternativement des tiroirs d'étanchéïté (11) et des tiroirs porte-solution (12), chacun de ces derniers (12) présentant une cavité (45) destinée à recevoir une solution (14) et présentant une partie inférieure débouchant à la face inférieure (47) dudit tiroir porte-solution (12), et les tiroirs d'étanchéïté (11) étant tels qu'ils referment la partie inférieure desdites cavités (45) et en ce que la tirette porte-substrats (7) est translatable dans le même plan que le tiroir inférieur de l'empilement, entre une position arrière où elle est dégagée de l'empilement et une position avant où après avoir chassé le tiroir inférieur de l'empilement, elle se trouve en-dessous de l'empilement.

2. Creuset selon la revendication 1 caractérisé en ce que la cavité (45) desdits tiroirs porte-solution (12) comporte au moins un évidement (40) destiné à recevoir une phase solide (48) permettant de maintenir ladite solution en saturation d'au moins un constituant.

3. Creuset selon une des revendications 1 ou 2 caractérisé en ce que le compartiment (2) comporte un fond (3) présentant une ouverture (6) disposée à l'aplomb de l'empilement de manière à permettre, lors du retour de la tirette porte-substrats (7) à sa position arrière, l'évacuation des bains d'épitaxie (14) utilisés.

4. Creuset selon une des revendications précédentes caractérisé en ce qu'un tiroir d'étanchéïté (11) consiste en une plaque pleine de même contour extérieur qu'un tiroir porte-solution (12).

## Claims

1. A crucible for multi-bath liquid phase epitaxy, in which substrates to be epitaxially coated are disposed in a slide comprising a substrate carrier, whose displacement permits of bringing the substrates successively into contact with the different baths of epitaxy, which said crucible comprises a compartment (2), in which isolating slides (11) and slides containing solutions (12) are alternately stacked, each of the latter slides (12) having a cavity (45) adapted to receive a said solution (14) and comprising a lower part opening on to the lower surface (47) of the said solution-containing slide (12) and the isolating slides (11) being such that they close the lower part of the said cavities (45), shile the slide comprising a substrate carrier (7) can be translated in the same plane as the lower slide of the stack of slides between a rear position in which it is disengaged from the stack and a front position in which, after having pushed the lower slide from the stack, it is situated under the stack.

2. A crucible as claimed in Claim 1, characterized in that the cavity (45) of the said solution-containing slides (12) has at least one recess (40) adapted to receive a solid phase (48) permitting of holding the said solution in saturation of at least one constituent.

3. A crucible as claimed in any one of Claims 1 or 2, characterized in that the compartment (2) comprises a bottom (3) having an opening (6) situated at right angles to the stack so as to permit during the return of the slide comprising a substrate carrier (7) to its rear position the emptying of the baths of epitaxy (14) used.

4. A crucible as claimed in any one of the preceding Claims, characterized in that an isolating slide (11) consists of a solid plate having the same outer contour as a solution-containing slide (12).

## Ansprüche

1. Tiegel zur Mehrschmelzen-Flüssigphasenepitaxie, wobei epitaxial zu bedeckende Substrate in einen Schieber mit einem Substratträger gegeben werden, dessen Verschiebung es ermöglicht, die Substrate nacheinander mit den jeweiligen Epitaxieschmelzen in Kontakt zu bringen, wobei dieser Tiegel einen Behälter (2) aufweist, in dem Abdichtungsschieber (11) und Schieber mit einer Lösung (12) wechselweise gestapelt sind, wobei jeder der letztgenannten Schieber (12) einen Hohlraum (45) aufweist zum Erhalten einer genannten Lösung (14) mit einem niedrigeren Teil, der an der unteren Fläche (47) des genannten Schiebers (12) mit der Lösung mündet, und wobei die Abdichtungsschieber (11) derart sind, daß sie den niedrigeren Teil der genannten Hohlräume (45) abschließen, und wobei der Schieber (7) mit dem Substratträger in derselben Ebene wie der untere Schieber des Stapels geradlinig verschiebbar ist und zwar zwischen einer hinteren Lage, in der er aus dem Stapel herausgeschoben ist, und einer vorderen Lage, in der er, nachdem der untere Schieber des Stapels herausgetrieben ist, unter dem Stapel liegt.

2. Tiegel nach Anspruch 1, dadurch gekennzeichnet, daß der Hohlraum (45) der genannten, die Lösung enthaltenden Schieber (12) wenigstens eine Ausnehmung (40) aufweist zum Erhalten einer festen Phase (48), wodurch es möglich ist, die genannte Lösung in gesättigter Form wenigstens eines der Bestandteile zu halten.

3. Tiegel nach einem der vorstehenden Ansprüche 1 bis 2, dadurch gekennzeichnet, daß der Behälter (2) einen Boden (3) aufweist mit einer Öffnung (6) senkrecht zu dem Stapel, derart, daß es möglich ist, beim Zurückkehren des Schiebers (7) mit dem Substratträger in die hintere Lage, die benutzten Epitaxieschmelzen (14) abzuführen.

4. Tiegel nach einem der vorstehenden Ansprüche, dadurch gekennzeichnet, daß ein Abdichtungsschieber (11) aus einer festen Platte mit demselben Umfang wie ein Schieber mit der Lösung (12) besteht.

1/4

FIG.1a

FIG.1b

FIG.1c

1-IV-PHF86-526

FIG.1d

FIG.1e

FIG.2a

FIG.2b

3/4

FIG.3a

FIG.3b

FIG.4a

FIG.4b

FIG.5a

FIG.5b

4/4

FIG.6

FIG.7

4-Ⅳ-PHF86-526